# EUROPEAN PATENT APPLICATION

(11) **EP 4 576 535 A1**
(43) Date of publication of application: **25.06.2025**
(21) Application number: 23859332.1
(22) Date of filing: 29.08.2023
(51) Int. Cl.: H02M 1/32

(54) **POWER SUPPLY CIRCUIT, ELECTRONIC DEVICE, AND COMMUNICATION SYSTEM**

(30) Priority: 01.09.2022 CN 202211066864
(71) Applicant: ZTE CORPORATION, Shenzhen, Guangdong 518057 (CN)
(72) Inventor: GUO, Zhongyin, Shenzhen, Guangdong 518057 (CN); WANG, Linguo, Shenzhen, Guangdong 518057 (CN); LIAO, Yexin, Shenzhen, Guangdong 518057 (CN)
(74) Representative: Ziebig Hengelhaupt Intellectual Property Attorneys Patentanwaltskanzlei PartGmbB
(86) International application number: PCT/CN2023/115451
(87) International publication number: WO 2024/046302

(57) **Abstract**

The present application relates to the technical field of electric power, and discloses a power supply circuit, an electronic device, and a communication system. The power supply circuit comprises a first power supply end, a second power supply end, a third power supply end, a fourth power supply end, a first inductor, a first switch module, a second switch module, and an auxiliary circuit; the first power supply end is connected to the second power supply end by means of the first switch module and the first inductor; the first power supply end is connected to the fourth power supply end by means of the first switch module and the second switch module; the auxiliary circuit comprises a target module, a third switch module, and a second inductor connected to the first inductor in parallel; a first connecting end of the target module is connected to the reference ground, a second connecting end of the target module is connected to a first connecting end of the second inductor, a second connecting end of the second inductor is connected to a first connecting end of the third switch module, and a second connecting end of the third switch module is connected to the reference ground.

## Description

### CROSS-REFERENCE TO RELATED APPLICATIONS

The present application claims priority to the Chinese patent application No. 202211066864.4 filed on September 01, 2022 to the China Patent Office, and entitled "POWER SUPPLY CIRCUIT, ELECTRONIC DEVICE, AND COMMUNICATION SYSTEM", the entire content of which is incorporated herein by reference.

### TECHNICAL FIELD

The present application relates to the technical field of circuits, in particular to a power supply circuit, an electronic device, and a communication system.

### BACKGROUND

In a communication direct current power supply system, a power supply circuit is needed to realize a function of direct current power supply.

The power supply circuit currently used generally includes an inductor and two switch tubes, and the function of direct current power supply is realized by controlling the two switch tubes. In the process of realizing the function of direct current power supply by using this power supply circuit, when one switch tube is switched on, the other switch tube may have the problem of a relatively heavy reverse recovery current, and such reverse recovery current will cause high voltage spikes at the two ends of the switch tube.

### SUMMARY

Embodiments of the present application provide a power supply circuit, an electronic device, and a communication system which can solve a problem that a reverse recovery current causes high voltage spikes at two ends of a switch tube in some cases.

In a first aspect, an embodiment of the present application provides a power supply circuit. The power supply circuit includes a first power supply end, a second power supply end, a third power supply end, a fourth power supply end, a first inductor, a first switch module, a second switch module, and an auxiliary circuit. The first power supply end is connected to the second power supply end by means of the first switch module and the first inductor. The first power supply end is connected to the fourth power supply end by means of the first switch module and the second switch module. The auxiliary circuit includes a target module, a third switch module, and a second inductor connected to the first inductor in parallel. A first connecting end of the target module is connected to a reference ground, a second connecting end of the target module is connected to a first connecting end of the second inductor, a second connecting end of the second inductor is connected to a first connecting end of the third switch module, and a second connecting end of the third switch module is connected to the reference ground.

In a second aspect, an embodiment of the present application provides an electronic device, including the power supply circuit according to the first aspect.

In a third aspect, an embodiment of the present application provides a communication system, including a load and the electronic device according to the second aspect, wherein the electronic device includes a power converter connected to the load, and the power converter is configured to supply power to the load.

### BRIEF DESCRIPTION OF DRAWINGS

FIG. 1 is a schematic diagram of a power supply circuit in some cases.
FIG. 2 is a schematic diagram of a power supply circuit provided by an embodiment of the present application.
FIG. 3 is a schematic diagram of a power supply circuit provided by an embodiment of the present application.
FIG. 4 is a schematic diagram of a power supply circuit in an inverting buck boost situation provided by an embodiment of the present application.
FIG. 5-1 is a schematic diagram of another power supply circuit in an inverting buck boost situation provided by an embodiment of the present application.
FIG. 5-2 is a schematic diagram of a power supply circuit that contains a clamping path of a target module in an inverting buck boost situation provided by an embodiment of the present application.
FIG. 5-3 is a schematic diagram of a power supply circuit that contains a clamping path of a third switch module in an inverting buck boost situation provided by an embodiment of the present application.
FIG. 6 is a schematic diagram of drive signals, current signals, and voltage signals for some devices in an embodiment of the present application.
FIG. 7-1 is a schematic diagram of a power supply circuit in a non-isolated buck situation provided by an embodiment of the present application.
FIG. 7-2 is a schematic diagram of another power supply circuit in a non-isolated buck situation provided by an embodiment of the present application.
FIG. 8-1 is a schematic diagram of a power supply circuit in a non-isolated boost situation provided by an embodiment of the present application.
FIG. 8-2 is a schematic diagram of another power supply circuit in a non-isolated boost situation provided by an embodiment of the present application.
FIG. 9 is a schematic diagram of an electronic device provided by an embodiment of the present application.
FIG. 10-1 is a schematic diagram of a communication system provided by an embodiment of the present application.
FIG. 10-2 is a schematic diagram of another communication system provided by an embodiment of the present application.

### DETAILED DESCRIPTION

Technical solutions in embodiments of the present application will be clearly described below in conjunction with accompanying drawings in the embodiments of the present application. Apparently, the described embodiments are part of the embodiments of the present application, not all of them. Based on the embodiments in the present application, all other embodiments obtained by those of ordinary skill in the art fall within the scope of protection of the present application.

Terms "first", "second" and the like in the specification and claims of the present application are used to distinguish similar objects, and are not used to describe a specific order or sequence. It should be understood that data so used may be interchanged in appropriate cases so that the embodiments of the present application can be implemented in an order other than those illustrated or described here, the objects distinguished by "first" and "second" are usually of one type, and the number of the objects is not limited, e.g., there may be one or a plurality of first objects. In addition, "and/or" in the specification and claims indicates at least one of connected objects, and a character "/" generally indicates that front and back associated objects are in an "or" relationship.

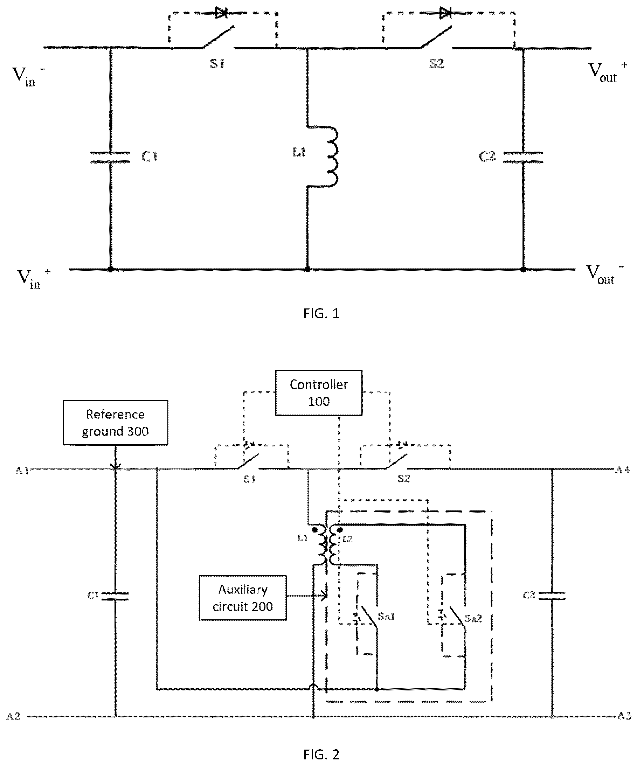

FIG. 1 is a schematic diagram of a circuit principle of a power supply circuit of an example in some cases. The power supply circuit of this example is an inverting buck boost (IBB) circuit, and more specifically, may be an inverting buck boost circuit under a direct current-common (DC-C) architecture. It needs to be understood that the circuit diagram shown in FIG. 1 is only an example for a purpose of better illustrating a technical problem existing in some cases, and a power supply circuit provided by an embodiment of the present application is not necessarily limited to the power supply circuit shown in FIG. 1. Referring to FIG. 1, the power supply circuit includes: an input negative end (Vin-), an input positive end (Vin+), an output negative end (Vout-), an output positive end (Vout+), a capacitor C1, a capacitor C2, an inductor L1, a first switch module S1, and a second switch module S2. When the function of direct current power supply is realized by using the circuit shown in FIG. 1, a relatively heavy current of the main power inductor L1 is followed in a body diode in the second switch module S2, which leads to the existence of a relatively heavy reverse recovery current in the body diode of the second switch module when the first switch module S1 is switched on, and causes high voltage spikes at the two ends of the second switch module S2.

To solve the problem of the high voltage spikes caused by the reverse recovery current, an embodiment of the present application provides a power supply circuit. The power supply circuit provided by the embodiment of the present application may have a variety of circuit forms. FIG. 2 to FIG. 3 show several forms of the power supply circuit provided by the embodiment of the present application. It needs to be understood that the forms shown in the figures are only examples and are not intended as limitations.

Referring to FIG. 2 to FIG. 3, the power supply circuit provided by the embodiment of the present application includes a first power supply end A1, a second power supply end A2, a third power supply end A3, a fourth power supply end A4, a first inductor L1, a first switch module S1, a second switch module S2, and an auxiliary circuit 200.

The first power supply end A1 is connected to the second power supply end A2 by means of the first switch module S1 and the first inductor L1.

The first power supply end A1 is connected to the fourth power supply end A4 by means of the first switch module S1 and the second switch module S2.

The auxiliary circuit 200 includes a target module Sa1, a third switch module Sa2, and a second inductor L2 connected to the first inductor L1 in parallel.

A first connecting end of the target module Sa1 is connected to a reference ground 300, a second connecting end of the target module Sa1 is connected to a first connecting end of the second inductor L2, a second connecting end of the second inductor L2 is connected to a first connecting end of the third switch module Sa2, and a second connecting end of the third switch module Sa2 is connected to the reference ground 300.

The power supply circuit provided by the embodiment of the present application may overcome the problem of high voltage spikes at the two ends of a second switch tube to a certain extent by introducing the auxiliary circuit 200 which includes the target module Sa1, the third switch module Sa2, and the second inductor L2 connected to the first inductor L1 in parallel, and having the first connecting end of the target module Sa1 and the second connecting end of the third switch module Sa2 in the auxiliary circuit 200 both connected to the reference ground 300.

In the embodiment of the present application, the target module may be a unidirectional switch-on device, or a switch module of a signal controllable type. For example, the target module may include at least one target diode, or, the target module includes a fourth switch module. It needs to be understood that the target module is shown in a form of the switch module in the accompanying drawing, which is only an example and is not intended as a limitation.

In the embodiment of the present application, the power supply circuit may include, but is not limited to, an inverting buck boost circuit under a direct current-common architecture, a non-isolated buck circuit under a direct current-common architecture, a non-isolated boost circuit under a direct current-common architecture, etc.

Based on the selected specific power supply circuit, the set position of the reference ground may vary. That is, the set position of the reference ground in the embodiment of the present application may change with the power supply circuit. For example, the set position of the reference ground may be located at the first power supply end or the second power supply end.

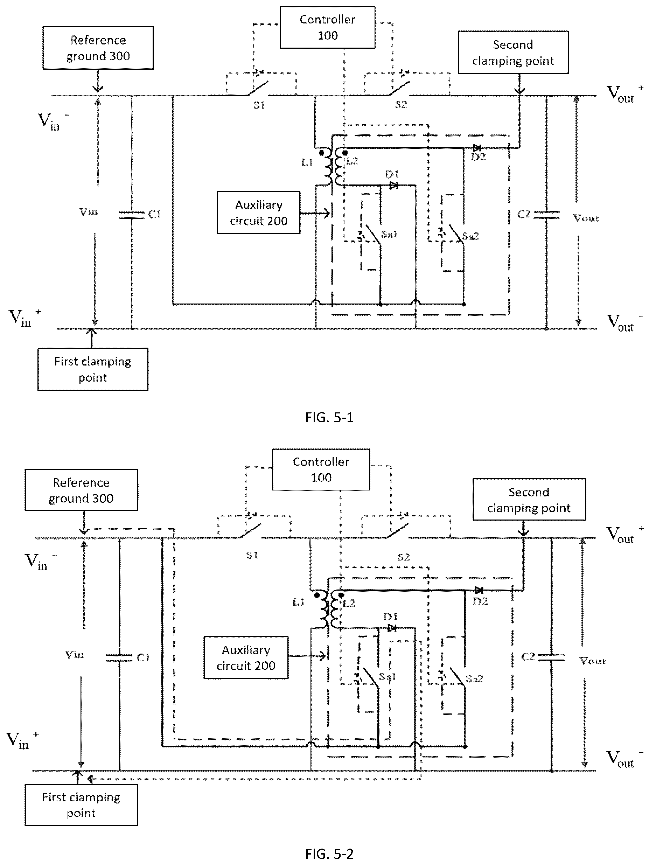

In a possible implementation, as shown in FIG. 2, the reference ground is arranged at the first power supply end. Accordingly, the auxiliary circuit may further include a first diode and a second diode (not shown in FIG. 2, referring to FIG. 5-1 hereafter). The second connecting end of the target module is connected to a first connecting end of the first diode, and a second connecting end of the first diode is connected to a first clamping point, where the first clamping point is arranged at the second power supply end or the third power supply end. The second connecting end of the second inductor is connected to a first connecting end of the second diode, and a second connecting end of the second diode is connected to a second clamping point, wherein the second clamping point is arranged at the fourth power supply end.

The power supply circuit may be the inverting buck boost circuit. The first power supply end may be a power supply input negative end, the second power supply end may be a power supply input positive end, the third power supply end may be a power supply output negative end, and the fourth power supply end may be a power supply output positive end.

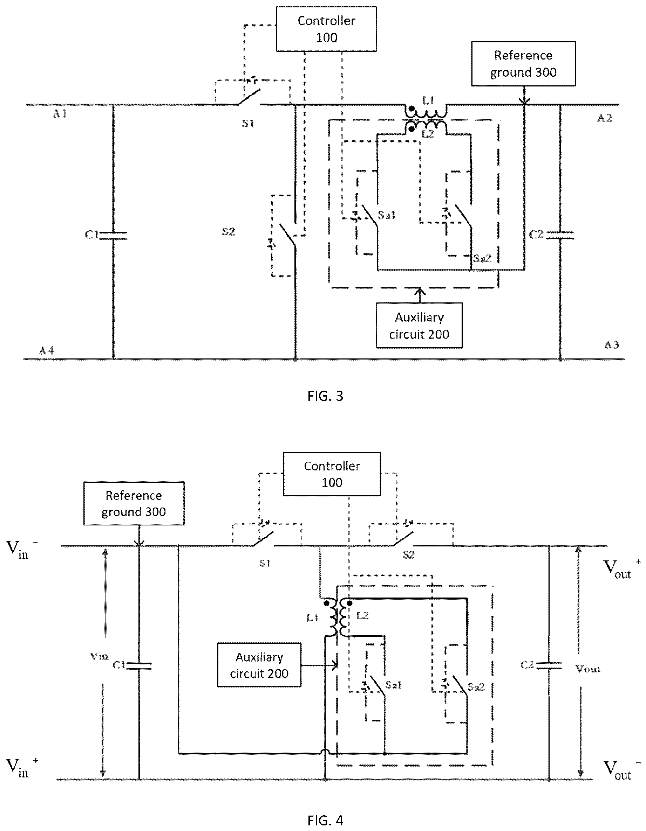

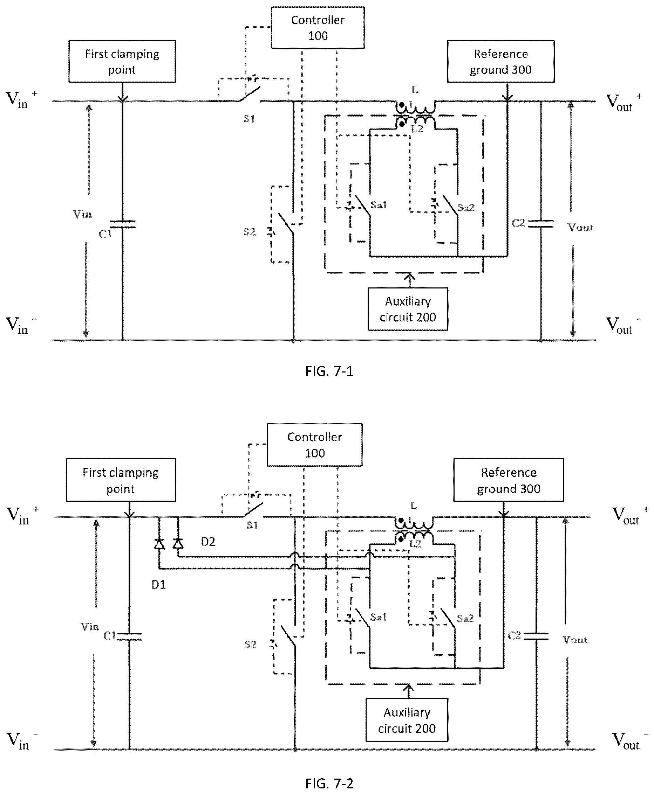

The reference ground in the power supply circuit provided by the embodiment of the present application may not only be arranged at the first power supply end, but in another possible implementation, the reference ground may also be arranged at the second power supply end, as shown in FIG. 3. Accordingly, the auxiliary circuit further includes a first diode and a second diode (not shown in FIG. 3, referring to FIG. 7-1 hereafter). The second connecting end of the target module is connected to a first connecting end of the first diode, and a second connecting end of the first diode is connected to a first clamping point, wherein the first clamping point is arranged at the first power supply end. The second connecting end of the second inductor is connected to a first connecting end of the second diode, and a second connecting end of the second diode is connected to the first clamping point.

The power supply circuit may be a non-isolated buck circuit under a direct current-common architecture. In this situation, the first power supply end is a power supply input positive end, the second power supply end is a power supply output positive end, the third power supply end is a power supply output negative end, and the fourth power supply end is a power supply input negative end.

The power supply circuit in the embodiment of the present application may not only be a non-isolated buck circuit, but may also be a non-isolated boost circuit. In this situation, the first power supply end is a power supply output positive end, the second power supply end is a power supply input positive end, the third power supply end is a power supply input negative end, and the fourth power supply end is a power supply output negative end.

The power supply circuit provided by embodiments of the present application is discussed below in conjunction with accompanying drawings in specific situations.

FIG. 4 is a schematic diagram of a power supply circuit of an example provided by an embodiment of the present application. The power supply circuit in FIG. 4 may be, for example, an inverting buck boost circuit under a direct current-common architecture. The power supply circuit shown in FIG. 4 may include four power supply ends, a first switch module S1, a second switch module S2, and an auxiliary circuit. The four power supply ends may include: a power supply input negative end, a power supply input positive end, a power supply output negative end, and a power supply output positive end. The power supply input negative end is connected to the power supply input positive end by means of the first switch module S1 and the first inductor L1. The power supply input negative end is connected to the power supply output positive end by means of the first switch module S1 and the second switch module S2.

In the circuit shown in FIG. 4, in a first stage, the first switch module S1 is switched on, the second switch module S2 is switched off, and an input voltage Vin of a power source stores energy to the inductor L1; and in a second stage, the first switch module S1 is switched off, the second switch module S2 is switched on, and the inductor L1 releases energy through the second switch module S2, and provides the energy to a load. Conversion of the input voltage Vin to an output voltage Vout is realized by repeating the above cycle.

In the process of conversion, after the second switch module S2 is switched off, a body diode of the second switch module S2 may continue the current in the inductor, and at this time, if the first switch module S1 is switched on, it will lead to a problem of a relatively heavy reverse recovery current existing in the second switch module S2.

In view of this, the embodiment of the present application introduces an auxiliary circuit 200 as in FIG. 4. Referring to FIG. 4, a part boxed in a dashed box in FIG. 4 is the introduced auxiliary circuit 200, and the auxiliary circuit includes a target module (exemplarily shown as a switch module Sa1 in the figure), a third switch module Sa2, and a second inductor L2 connected to the first inductor L1 in parallel. A first connecting end of the target module is connected to a reference ground 300, a second connecting end of the target module is connected to a first connecting end of the second inductor L2, a second connecting end of the second inductor L2 is connected to a first connecting end of the third switch module Sa2, and a second connecting end of the third switch module Sa2 is connected to the reference ground 300.

The auxiliary circuit may be an auxiliary soft switching circuit. For example, it may be a zero voltage turn (ZVT) circuit. The second inductor L2 may be a coupling inductor. A set position of the reference ground may be located at the power supply input negative end.

Before the first switch module S1 is switched on, the auxiliary circuit 200 may be controlled to be switched on. At this time the inductor L2, the target module Sa1, and the third switch module Sa2 form a closed loop to control the body diode of the second switch module S2 to be switched off at a zero current without a reverse recovery loss, while the first switch module S1 may be switched on at a zero voltage.

The power supply circuit shown in FIG. 4 provided by the embodiment of the present application may overcome the problem of high voltage spikes at two ends of the second switch module S2 in the inverting buck boost circuit to a certain extent by introducing the auxiliary circuit 200 which includes the target module Sa1, the third switch module Sa2, and the second inductor L2 connected to the first inductor in parallel, and having the first connecting end of the target module Sa1 and the second connecting end of the third switch module Sa2 in the auxiliary circuit 200 both connected to the reference ground 300.

However, the auxiliary circuitry may change between switching on the third switch module Sa2 and switching off the third switch module Sa2 repeatedly in the process that the auxiliary circuit 200 realizes the soft switching function (e.g., the second switch module is switched off at the zero current, and the first switch module is switched on at the zero voltage) of the first switch module S1 and the second switch module S2. Specifically, when the auxiliary circuit 200 is configured to be switched on by the loop formed by Sa1 and Sa2, the third switch module Sa2 may be switched on at this time. If the third switch module Sa2 is switched on, impedance of the loop formed by the auxiliary circuit may be negligible, it may be regarded as a short circuit at two ends of the inductor L1, and currents in the inductor L1 all pass through the loop formed by the auxiliary circuit. When the auxiliary circuit is configured to be switched off by the loop formed by Sa1 and Sa2, the third switch module Sa2 may be switched off at this time. When the third switch module Sa2 is switched off, due to the existence of a high change rate of a current on the loop of the auxiliary circuit itself (i.e., the current changes faster per unit of time), the current in the inductor L2 may pass through the target module Sa1 and the third switch module Sa2, which in turn causes a problem of a reverse recovery current. In particular, due to the existence of a leakage inductance on the auxiliary circuit, the leakage inductance is excited by the reverse recovery current, and some devices in the auxiliary circuit may themselves generate large voltage spikes, which may reach more than twice the input voltage Vin in some cases. For example, in a case of a lightning strike, the input voltage Vin may be shocked to a very high voltage in an instant, which is prone to cause damage to the Sa1 device in the auxiliary circuit. To prevent the damage to the Sa1 device in the auxiliary circuit, higher requirements will be put forward when the Sa1 device is selected, which will undoubtedly affect a performance or increase a cost.

In order to further reduce the voltage spikes generated at the two ends of the device in the auxiliary circuit, the embodiment of the present application introduces clamping points in the power supply circuit. This is discussed below with reference to FIG. 5-1.

FIG. 5-1 is a schematic diagram of a power supply circuit of another example provided by an embodiment of the present application. On the basis of the power supply circuit shown in FIG. 4, two diodes, i.e., the first diode D1 and the second diode D2, and as well as two clamping points, i.e., the first clamping point and the second clamping point are added in the power supply circuit shown in FIG. 5-1. In the power supply circuit shown in FIG. 5-1, the first clamping point is connected to the first diode D1, and the second clamping point is connected to the second diode D2.

As shown in FIG. 5-1, the auxiliary circuit 200 may include the first diode D1 and the second diode D2. The second connecting end of the target module Sa1 is connected to a first connecting end of the first diode D1, and a second connecting end of the first diode D1 is connected to the first clamping point, wherein the first clamping point is arranged at the power supply input positive end or the power supply output negative end. The second connecting end of the second inductor L2 is connected to a first connecting end of the second diode D2, and a second connecting end of the second diode D2 is connected to the second clamping point, wherein the second clamping point is arranged at the power supply output positive end. It needs to be understood that the second connecting end of the second inductor is connected to the first connecting end of the third switch module, the second connecting end of the second inductor L2 is further connected to the first connecting end of the second diode D2, and thus the first connecting end of the second diode D2 may be connected to the first connecting end of the third switch module.

The power supply circuit shown in FIG. 5-1 uses the input negative end as the reference ground, the first connecting end of the target module is connected to the reference ground, and the second connecting end of the target module Sa1 is connected to the first clamping point by means of the first diode D1. In this way, a voltage stress of the target module in the auxiliary circuit may be clamped to the voltage between the reference ground and the first clamping point. Also, since the first clamping point may be arranged at the power supply input positive end or the power supply output negative end in FIG. 5-1, the voltage between the reference ground and the first clamping point is Vin.

In FIG. 5-1, the first connecting end of the third switch module Sa2 is connected to the second clamping point by means of the second diode D2. The second connecting end of the third switch module Sa2 is connected to the reference ground. In this way, the voltage stress of the third switch module Sa2 in the auxiliary circuit may be clamped to the voltage between the reference ground and the second clamping point. Also, since the second clamping point is arranged at or connected to the power supply output positive end in FIG. 5-1, the voltage between the reference ground and the second clamping point is (Vin+Vout).

Thus, in the above manner, the voltage spike stress of the target module Sa1 may be clamped to the voltage between the reference ground and the first clamping point, i.e., Vin, and energy beyond Vin is fed back to the power supply input end without loss. At the same time, in the above manner, the spike voltage stress of the third switch module Sa2 may be clamped to the voltage between the reference ground and the second clamping point, i.e., (Vin+Vout), and energy beyond (Vin+Vout) is fed back to the output end. In this way, the voltage spike generated at the two ends of the target module Sa1 in the auxiliary circuit and the voltage spike generated between the two ends of the third switch module Sa2 in the auxiliary circuit may be reduced. At the same time, it needs to be understood that in such a clamping manner, the voltage generated at the two ends of the target module Sa1 is clamped to the input negative end and the input positive end, so that the problem of the voltage stress at the two ends of the target module Sa1 in the auxiliary circuit may be solved without loss. Similarly, it needs to be understood that in such a clamping manner, the voltage generated between the two ends of the third switch module Sa2 is clamped to the input negative end and the output positive end, so that the problem of the voltage stresses at the two ends of the third switch module Sa2 in the auxiliary circuit may be solved without loss.

Other manners of reducing the voltage spikes generated at the two ends of the device in the auxiliary circuit may exist in some cases, but most of the manners in the related art are manners of lossy absorption of a voltage stress, not the manner of lossless absorption of the voltage stress in the power supply circuit in the embodiment of the present application, as shown in FIG. 5-1.

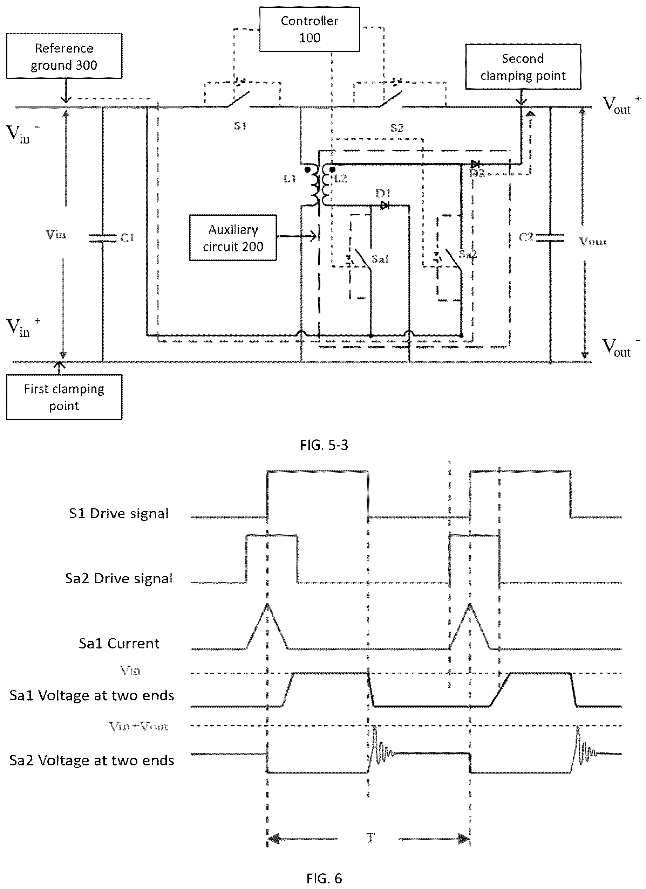

In order to better show a clamping path of the target module Sa1 and a clamping path of the third switch module Sa2, it is discussed below in conjunction with FIG. 5-2 and FIG. 5-3.

FIG. 5-2 and FIG. 5-3 are each a schematic diagram of a power supply circuit of another example provided by an embodiment of the present application. FIG. 5-2 marks a clamping path of the target module Sa1 in a form of a dashed line based on FIG. 5-1. FIG. 5-3 marks a clamping path of the third switch module Sa2 in a form of a dashed line based on FIG. 5-1. That is, the clamping path of the target module Sa1 may be shown as the dashed line in FIG. 5-2, and the clamping path of the third switch module Sa2 may be shown as the dashed line in FIG. 5-3.

As can be seen from FIG. 5-2, the voltage stress of the target module Sa1 is clamped to be equal to Vin. As can be seen from FIG. 5-3, the voltage stress of the third switch module Sa2 is clamped to be equal to Vin plus Vout. In the above manner, the voltage stresses of the target module Sa1 and the third switch module Sa2 in the auxiliary circuit are clamped to be equal to Vin and (Vin+Vout) respectively without loss, and the voltage spikes generated at the two ends of each device in the auxiliary circuit may be reduced. Compared to other manners of reducing voltage stress spikes, the power supply circuit shown in FIG. 5-1 may not only lower voltage withstand levels of the target module Sa1 and the third switch module Sa2, which solves the problem of voltage stresses of the devices in the auxiliary circuit without loss, but also improves overall efficiency of the power source as well as the reliability of the devices in high-voltage input scenarios, such as a lightning strike.

It needs to be noted that, as shown in FIG. 5-1, the embodiment of the present application takes advantage of the reference ground 300 connected to the input negative end, and uses a clamping manner to reduce the voltage stresses of the target module Sa1 as well as the third switch module Sa2 without loss, which has a good application effect in an IBB topology circuit. That is, in the IBB topology circuit, independent of the limitations of input voltage and output voltage ranges, the voltage stresses on the two ends of the target module Sa1 as well as the two ends of the third switch module Sa2 in the auxiliary circuit can be effectively clamped, and a stress optimization effect is better.

In some embodiments, in a case of a lightning strike, the input voltage Vin may be shocked to a very high voltage in an instant. In the power supply circuit provided by the embodiment of the present application, the two ends of the target module Sa1 only need to withstand the Vin voltage, compared to other manners in which the spike voltage stress is much higher than the input voltage Vin, the voltage stress of the target module Sa1 in the embodiment of the present application is controlled to be within the input voltage Vin, and the reliability is high.

It needs to be noted that the present application utilizes the input negative end as the reference ground of the target module Sa1 as well as the third switch module Sa2 to reduce the voltage stresses on the two ends of each device in the auxiliary circuit, and the manner of clamping the voltage spike stress of the target module Sa1 to be equal to the input voltage Vin enhances a voltage resistance of the soft switching circuit, and has a better lightning prevention effect in the IBB topology circuit.

A schematic diagram of currents, voltages, and drive signals for some related devices in FIG. 5-1 and FIG. 5-2 may be shown in FIG. 6. As can be seen from FIG. 6, the maximum voltage between the two ends of Sa1 is clamped to Vin, and the maximum voltages between the two ends of Sa2 is clamped to (Vin+Vout).

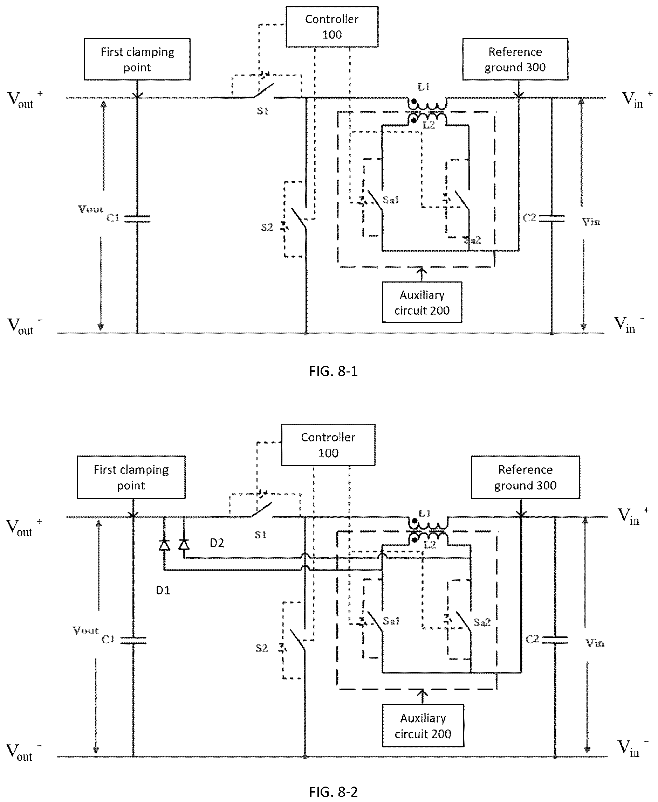

The above shows, by way of example, a situation in which the power supply circuit provided by the embodiment of the present application is applied to the IBB topology circuit, and it needs to be understood that the power supply circuit provided by the embodiment of the present application may also be applied to other situations. The following discusses, in conjunction with FIG. 7-1 and FIG. 7-2, a situation in which a power supply circuit provided by an embodiment of the present application is applied to a non-isolated buck circuit, and discusses, in conjunction with FIG. 8-1 and FIG. 8-2, a situation in which a power supply circuit provided by an embodiment of the present application is applied to a non-isolated boost circuit. It needs to be understood that these situations listed in the embodiments of the present application are only examples and are not intended as limitations.

FIG. 7-1 is a schematic diagram of a power supply circuit of an example provided by an embodiment of the present application. The power supply circuit in FIG. 7-1 may be, for example, a non-isolated buck circuit under a direct current-common architecture. The power supply circuit shown in FIG. 7-1 may include four power supply ends, a first switch module S1, a second switch module S2, and an auxiliary circuit. The four power supply ends may include: a power supply input negative end, a power supply input positive end, a power supply output negative end, and a power supply output positive end. The power supply input positive end is connected to the power supply output positive end by means of the first switch module S1 and the first inductor L1. The power supply input positive end is connected to the power supply output negative end by means of the first switch module S1 and the second switch module S2.

In the circuit shown in FIG. 7-1, in a first stage, the first switch module S1 is switched on, the second switch module S2 is switched off, and an input voltage Vin of a power source stores energy to the inductor L1; and in a second stage, the first switch module S1 is switched off, the second switch module S2 is switched on, and the inductor L1 releases energy through the second switch module S2 to provide the energy to a load, and conversion of the input voltage Vin to an output voltage Vout is realized by repeating the above cycle.

In the process of conversion, after the second switch module S2 is switched off, a body diode of the second switch module S2 may follow the current in the inductor, and at this time, if the first switch module S1 is switched on, it will lead to a problem that a relatively heavy reverse recovery current exists in the second switch module S2.

In view of this, the embodiment of the present application introduces an auxiliary circuit 200 in FIG. 7-1. Referring to FIG. 7-1, a part boxed in a dashed box in FIG. 7-1 is the introduced auxiliary circuit 200, and the auxiliary circuit includes a target module (exemplarily shown as a switch module Sa1 in the figure), a third switch module Sa2, and a second inductor L2 connected to the first inductor L1 in parallel. A first connecting end of the target module Sa1 is connected to a reference ground 300, a second connecting end of the target module Sa1 is connected to a first connecting end of the second inductor L2, a second connecting end of the second inductor L2 is connected to a first connecting end of the third switch module Sa2, and a second connecting end of the third switch module Sa2 is connected to the reference ground 300.

The auxiliary circuit may be an auxiliary soft switching circuit. For example, it may be a zero voltage turn (ZVT) circuit. The second inductor L2 may be a coupling inductor. A set position of the reference ground may be located at the power supply output positive end.

Before the first switch module S1 is switched on, the auxiliary circuit 200 may be controlled to be switched on. At this time the inductor L2, the target module Sa1, and the third switch module Sa2 form a closed loop to control the body diode of the second switch module S2 to be switched off at a zero current without a reverse recovery loss, while the first switch module S1 may be switched on at a zero voltage.

The power supply circuit shown in FIG. 7-1 provided by the embodiment of the present application may overcome the problem of high voltage spikes at two ends of the second switch module S2 in the non-isolated buck circuit to a certain extent by introducing the auxiliary circuit 200 which includes the target module Sa1, the third switch module Sa2, and the second inductor L2 connected to the first inductor in parallel, and having the first connecting end of the target module Sa1 and the second connecting end of the third switch module Sa2 in the auxiliary circuit 200 both connected to the reference ground 300.

However, the auxiliary circuitry may switch change between switching on the third switch module Sa2 and switching off the third switch module Sa2 repeatedly in the process that the auxiliary circuit 200 realizes the soft switching function (e.g., the second switch module is switched off at the zero current, and the first switch module is switched on at the zero voltage) of the first switch module S1 and the second switch module S2. Specifically, when the auxiliary circuit 200 is configured to be switched on by the loop formed by Sa1 and Sa2, the third switch module Sa2 may be switched on at this time. If the third switch module Sa2 is switched on, impedance of the loop formed by the auxiliary circuit may be negligible, it may be regarded as a short circuit at two ends of the inductor L1, and currents in the inductor L1 all pass through the loop formed by the auxiliary circuit. When the auxiliary circuit is configured to be switched off by the loop formed by Sa1 and Sa2, the third switch module Sa2 may be switched off at this time. When the third switch module Sa2 is switched off, due to the existence of a high change rate of a current on the loop of the auxiliary circuit itself (i.e., the current changes faster per unit of time), the current in the inductor L2 may pass through the target module Sa1 and the third switch module Sa2, which in turn causes the problem of reverse recovery current. In particular, due to the existence of a leakage inductance on the auxiliary circuit, the leakage inductance is excited by the reverse recovery current, and some devices in the auxiliary circuit may themselves generate large voltage spikes, which may reach more than twice the input voltage Vin in some cases. For example, in a case of a lightning strike, the input voltage Vin may be shocked to a very high voltage in an instant, which is prone to cause damage to the Sa1 device in the auxiliary circuit. To prevent the damage to the Sa1 device in the auxiliary circuit, higher requirements will be put forward when the Sa1 device is selected, which will undoubtedly affect a performance or increase a cost.

In order to further reduce the voltage spikes generated at the two ends of the device in the auxiliary circuit, the embodiment of the present application introduces clamping points in the power supply circuit. This is discussed below with reference to FIG. 7-2.

FIG. 7-2 is a schematic diagram of a power supply circuit of another example provided by an embodiment of the present application. On the basis of the power supply circuit shown in FIG. 7-1, adds two diodes, i.e., the first diode D1 and the second diode D2 and a clamping point, i.e., the first clamping point are added in the power supply circuit shown in FIG. 7-1. In FIG. 7-2, the first diode D1 and the second diode D2 are both connected to the first clamping point.

As shown in FIG. 7-2, the auxiliary circuit 200 may include the first diode D1 and the second diode D2. A second connecting end of the target module Sa1 is connected to a first connecting end of the first diode D1, and a second connecting end of the first diode D1 is connected to a first clamping point, wherein the first clamping point is arranged at the first power supply end.

A second connecting end of the second inductor L2 is connected to a first connecting end of the second diode D2, and a second connecting end of the second diode D2 is connected to the first clamping point.

The power supply circuit shown in FIG. 7-2 uses the output positive end as the reference ground, assisting a first switch tube Sa1 to be clamped to the first clamping point of the input positive end through the first diode D1, and assisting a second switch tube Sa2 to be clamped to the first clamping point of the output positive end through the second diode D2.

The power supply circuit shown in FIG. 7-2 uses the output positive end as the reference ground, the first connecting end of the target module Sa1 is connected to the reference ground, and the second connecting end of the target module Sa1 is connected to the first clamping point by means of the first diode D1. In this way, a voltage stress of the target module Sa1 in the auxiliary circuit may be clamped to a voltage between the reference ground and the first clamping point. Also, since the first clamping point may be arranged at the power supply input positive end in FIG. 7-2, the voltage between the reference ground and the first clamping point is (Vin-Vout).

In FIG. 7-2, the first connecting end of the third switch module Sa2 is connected to the first clamping point by means of the second diode D2. The second connecting end of the third switch module Sa2 is connected to the reference ground. In this way, the voltage stress of the third switch module Sa2 in the auxiliary circuit may be clamped to a voltage between the reference ground and the first clamping point. Also, since the first clamping point is arranged at or connected to the power supply input positive end in FIG. 7-2, the voltage between the reference ground and the first clamping point is (Vin-Vout).

As can be seen, in the above way, the voltage spike stress of the target module Sa1 may be clamped to the voltage between the reference ground and the first clamping point, i.e., (Vin-Vout), and energy beyond (Vin-Vout) is fed back to the power supply end without loss. At the same time, in the above way, the spike voltage stress of the third switch module Sa2 may be clamped to the voltage between the reference ground and the first clamping point, i.e., (Vin-Vout), and energy beyond (Vin-Vout) is fed back to the power supply end. In this way, the voltage spikes generated at the two ends of the target module Sa1 in the auxiliary circuit and the voltage spikes generated at the two ends of the third switch module Sa2 in the auxiliary circuit may be reduced. At the same time, it needs to be understood that such a clamping manner clamps the voltages generated at the two ends of the target module Sa1 to the input positive end and the output positive end, so that the problem of the voltage stresses at the two ends of the target module Sa1 in the auxiliary circuit may be solved without loss. Similarly, it needs to be understood that such a clamping manner clamps the voltages generated at the two ends of the third switch module Sa2 to the input positive end and the output positive end, so that the problem of the voltage stresses at the two ends of the third switch module Sa2 in the auxiliary circuit may be solved without loss.

Other manners of reducing the voltage spikes generated at the two ends of the device in the auxiliary circuit may exist in some cases, but most of the manners in the related art are manners of lossy absorption of a voltage stress, not the manner of lossless absorption of the voltage stress in the power supply circuit in the embodiment of the present application, as shown in FIG. 7-2.

FIG. 8-1 is a schematic diagram of a power supply circuit of an example provided by an embodiment of the present application. The power supply circuit in FIG. 8-1 may be, for example, a non-isolated boost circuit under a direct current-common architecture. The power supply circuit shown in FIG. 8-1 may include four power supply ends, a first switch module S1, a second switch module S2, and an auxiliary circuit. The four power supply ends may include: a power supply input negative end, a power supply input positive end, a power supply output negative end, and a power supply output positive end. The power supply output positive end is connected to the power supply input positive end by means of the first switch module S1 and the first inductor L1. The power supply output positive end is connected to the power supply output negative end by means of the first switch module S1 and the second switch module S2.

In the circuit shown in FIG. 8-1, in a first stage, the second switch module S2 is switched on, the first switch module S1 is switched off, and an input voltage Vin of a power source stores energy to the inductor L1; and in a second stage, the second switch module S2 is switched off, the first switch module S1 is switched on, and the inductor L1 releases energy through the first switch module S1 to provide the energy to a load, and boost conversion of the input voltage Vin to an output voltage Vout is realized by repeating the above cycle.

In the process of conversion, after the second switch module S2 is switched off, a body diode of the second switch module S2 may follow the current in the inductor, and at this time, if the first switch module S1 is switched on, there may be a problem of a relatively heavy reverse recovery current.

In view of this, the embodiment of the present application introduces an auxiliary circuit 200 in FIG. 8-1. Referring to FIG. 8-1, a part boxed in a dashed box in FIG. 8-1 is the introduced auxiliary circuit 200, and the auxiliary circuit includes a target module (exemplarily shown as a switch module Sa1 in the figure), a third switch module Sa2, and a second inductor L2 connected to the first inductor L1 in parallel. A first connecting end of the target module Sa1 is connected to a reference ground 300, a second connecting end of the target module Sa1 is connected to a first connecting end of the second inductor L2, a second connecting end of the second inductor L2 is connected to a first connecting end of the third switch module Sa2, and a second connecting end of the third switch module Sa2 is connected to the reference ground 300.

The auxiliary circuit may be an auxiliary soft switching circuit. For example, it may be a zero voltage turn (ZVT) circuit. The second inductor L2 may be a coupling inductor. A set position of the reference ground may be located at the power supply input positive end.

Before the first switch module S1 is switched on, the auxiliary circuit 200 may be controlled to be switched on. At this time the inductor L2, the target module Sa1, and the third switch module Sa2 form a closed loop to control the body diode of the second switch module S2 to be switched off at a zero current without a reverse recovery loss, while the first switch module S1 may be switched on at a zero voltage.

The power supply circuit shown in FIG. 8-1 provided by the embodiment of the present application may reduce a problem of high voltage spikes at two ends of the first switch tube S1 in the non-isolated boost circuit to a certain extent by introducing the auxiliary circuit 200 which includes the target module Sa1, the third switch module Sa2, and the second inductor L2 connected to the first inductor in parallel, and having the first connecting end of the target module Sa1 and the second connecting end of the third switch module Sa2 in the auxiliary circuit 200 both connected to the reference ground 300.

However, the auxiliary circuitry may change between switching on the third switch module Sa2 and switching off the third switch module Sa2 repeatedly in the process that the auxiliary circuit 200 realizes a soft switching function (e.g., the second switch module is switched off at the zero current, and the first switch module is switched on at the zero voltage) of the first switch module S1 and the second switch module S2. Specifically, when the auxiliary circuit 200 is configured to be switched on by the loop formed by Sa1 and Sa2, the third switch module Sa2 may be switched on at this time. If the third switch module Sa2 is switched on, impedance of the loop formed by the auxiliary circuit may be negligible, it may be regarded as a short circuit at two ends of the inductor L1, and currents in the inductor L1 all pass through the loop formed by the auxiliary circuit. When the auxiliary circuit is configured to be switched off by the loop formed by Sa1 and Sa2, the third switch module Sa2 may be switched off at this time. When the third switch module Sa2 is switched off, due to the existence of a high change rate of a current on the loop of the auxiliary circuit itself (i.e., the current changes faster per unit of time), the current in the inductor L2 may pass through the target module Sa1 and the third switch module Sa2, which in turn causes a problem of a reverse recovery current. In particular, due to the existence of a leakage inductance on the auxiliary circuit, the leakage inductance is excited by the reverse recovery current, and some devices in the auxiliary circuit may themselves generate large voltage spikes, which may reach more than twice the input voltage Vin in some cases. For example, in a case of a lightning strike, the input voltage Vin may be shocked to a very high voltage in an instant, which is prone to cause damage to the device in the auxiliary circuit. To prevent the damage to the device in the auxiliary circuit, higher requirements will be put forward when the device is selected, which will undoubtedly affect a performance or increase a cost.

In order to further reduce the voltage spikes generated at the two ends of the device in the auxiliary circuit, the embodiment of the present application introduces clamping points in the power supply circuit. This is discussed below with reference to FIG. 8-2.

FIG. 8-2 is a schematic diagram of a power supply circuit of another example provided by an embodiment of the present application. On the basis of FIG. 8-1, two diodes, i.e., the first diode D1 and the second diode D2, and a clamping point, i.e., the first clamping point are added in FIG. 8-2. In FIG. 8-2, the first diode D1 and the second diode D2 are both connected to the first clamping point.

As shown in FIG. 8-2, the auxiliary circuit 200 may include the first diode D1 and the second diode D2. A second connecting end of the target module Sa1 is connected to a first connecting end of the first diode D1, and a second connecting end of the first diode D1 is connected to a first clamping point, wherein the first clamping point is arranged at the first power supply end.

A second connecting end of the second inductor L2 is connected to a first connecting end of the second diode D2, and a second connecting end of the second diode D2 is connected to the first clamping point.

The power supply circuit shown in FIG. 8-2 uses the input positive end as the reference ground, assisting a first switch tube Sa1 to be clamped to the first clamping point of the output positive end through the first diode D1, and assisting the second switch tube Sa2 to be clamped to the first clamping point of the output positive end through the second diode D2.

The power supply circuit shown in FIG. 8-2 uses the output positive end as the reference ground, the first connecting end of the target module Sa1 is connected to the reference ground, and the second connecting end of the target module Sa1 is connected to the first clamping point by means of the first diode D1. In this way, a voltage stress of the target module Sa1 in the auxiliary circuit may be clamped to a voltage between the reference ground and the first clamping point. Also, since the first clamping point may be arranged at the power supply input positive end in FIG. 8-2, the voltage between the reference ground and the first clamping point is (Vout-Vin).

In FIG. 8-2, the first connecting end of the third switch module Sa2 is connected to the first clamping point by means of the second diode D2. The second connecting end of the third switch module Sa2 is connected to the reference ground. In this way, the voltage stress of the third switch module Sa2 in the auxiliary circuit may be clamped to a voltage between the reference ground and the first clamping point. Also, since the first clamping point is arranged to be connected at the power supply input positive end in FIG. 8-2, the voltage between the reference ground and the first clamping point is (Vout-Vin).

As can be seen, in the above way, the voltage spike stress of the target module Sa1 may be clamped to the voltage between the reference ground and the first clamping point, i.e., (Vout-Vin), and energy beyond (Vout-Vin) is fed back to the power supply end without loss. At the same time, in the above way, the spike voltage stress of the third switch module Sa2 may be clamped to the voltage between the reference ground and the first clamping point, i.e., (Vout-Vin), and energy beyond (Vout-Vin) is fed back to the power supply end. In this way, the voltage spikes generated at the two ends of the target module Sa1 in the auxiliary circuit and the voltage spikes generated at the two ends of the third switch module Sa2 in the auxiliary circuit may be reduced. At the same time, it needs to be understood that such a clamping manner clamps the voltages generated at the two ends of the target module Sa1 to the input positive end and the output positive end, so that the problem of the voltage stresses at the two ends of the target module Sa1 in the auxiliary circuit may be solved without loss. Similarly, it needs to be understood that such a clamping manner clamps the voltages generated at the two ends of the third switch module Sa2 to the input positive end and the output positive end, so that the problem of the voltage stresses at the two ends of the third switch module Sa2 in the auxiliary circuit may be solved without loss.

Other manners of reducing the voltage spikes generated at the two ends of the device in the auxiliary circuit may exist in some cases, but most of the manners in the related art are manners of lossy absorption of a voltage stress, not the manner of lossless absorption of the voltage stress in the power supply circuit in the embodiment of the present application, as shown in FIG. 8-2.

It needs to be noted that in a case where the power supply circuit provided by the embodiment of the present application includes the first diode and the second diode, a current passing through the first diode flows from the first connecting end of the first diode to the second connecting end of the first diode; and a current passing through the second diode flows from the first connecting end of the second diode to the second connecting end of the second diode. In this way, unidirectional switch-on characteristics of these two diodes may be fully utilized to limit a flow direction of the currents, and to better perform a clamping effect on the voltages at the two ends of the target module and the third switch module.

In addition, it needs to be noted that the individual switch module in the embodiment of the present application may be an element having a unidirectional switch-on characteristic or a signal controllable element, such as a triode, a field-effect transistor or a relay. That is, the first switch module, the second switch module, the third switch module, and the fourth switch module referred to in the embodiment of the present application may each be a triode, a field-effect transistor, or a relay. The field-effect transistor may be, for example, a metal-oxide-semiconductor field-effect transistor (MOSFET).

At the same time, it needs to be understood that while a controller is shown in a plurality of accompanying drawings of the present application, it needs to be understood that the power supply circuit provided by the embodiment of the present application may have no controller in a case where the switch modules do not need to be controlled by the controller. That is, the controller shown in the accompanying drawings may not be a necessary part.

The power supply circuit provided in the embodiment of the present application may also include a controller if needed. For example, in a case where the switch modules are signal controllable elements, e.g., in a case where the first switch module is a first field-effect transistor, the second switch module is a second field-effect transistor, and the third switch module is a third field-effect transistor, gates of the first field-effect transistor, the second field-effect transistor, and the third field-effect transistor may all be connected to the controller, and switching on or off of the first field-effect transistor, the second field-effect transistor, or the third field-effect transistor is controlled by the controller. In this way, switching on and off of the individual switching modules may be conveniently controlled.

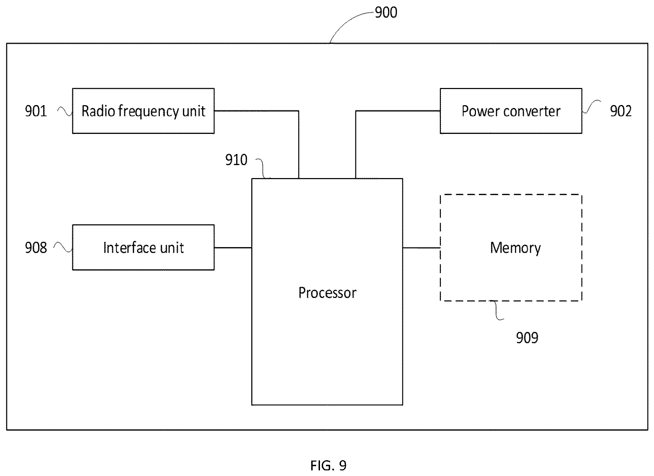

FIG. 9 is a schematic diagram of a hardware structure of an electronic device of an embodiment of the present application. Referring to FIG. 9, the electronic device 900 provided by the embodiment of the present application includes, but is not limited to, parts such as: a radio frequency unit 901, a power converter 902, an interface unit 908, a memory 909, and a processor 910. The power converter may be a direct current-direct current power converter. It needs to be understood that the structure of the electronic device shown in FIG. 9 does not constitute a limitation of the electronic device, and the electronic device may include more or fewer parts than illustrated, or a combination of certain parts, or a different arrangement of parts, which will not be described herein.

It may be understood by those of skill in the art that the electronic device 900 provided by the embodiment of the present application may further include: a power supply circuit. The power supply circuit may be any of the power supply circuits provided by the above embodiments of the present application. For example, the power supply circuit may include a first power supply end, a second power supply end, a third power supply end, a fourth power supply end, a first inductor, a first switch module, a second switch module, and an auxiliary circuit. The first power supply end is connected to the second power supply end by means of the first switch module and the first inductor. The first power supply end is connected to the fourth power supply end by means of the first switch module and the second switch module. The auxiliary circuit includes a target module, a third switch module, and a second inductor connected to the first inductor in parallel. A first connecting end of the target module is connected to a reference ground, a second connecting end of the target module is connected to a first connecting end of the second inductor, a second connecting end of the second inductor is connected to a first connecting end of the third switch module, and a second connecting end of the third switch module is connected to the reference ground.

The power supply circuit may be located, for example, in the power converter 902. In this way, by solving the problem of a high voltage spike caused by a reverse recovery current in the power supply circuit and by introducing one or more clamping points, the electronic device may be made to operate more smoothly, thereby improving the reliability and safety.

The electronic device provided in the embodiment of the present application may be, by way of example, a base station. In this way, the smooth operation of the base station may be better ensured under extreme adverse conditions (e.g., a lightning condition).

The following is a brief description of some parts in the electronic device.

The radio frequency unit 901 may be configured to receive and send information, e.g., for signal receiving and sending. Specifically, downlink data from a network device may be received and then given to a processor 910 for processing. Additionally, uplink data is sent to the network device. Typically, the radio frequency unit 901 includes, but is not limited to, an antenna, at least one amplifier, a transceiver, a coupler, a low noise amplifier, a duplexer, etc. In addition, the radio frequency unit 901 may further communicate with a network and other devices via a wireless communication system.

An interface unit 908 is an interface for an external apparatus to be connected to the electronic device 900. The interface unit 908 may be configured to receive an input (e.g., data information, power, etc.) from an external apparatus and transmit the received input to one or more components in the electronic device 900 or may be configured to transmit data between the electronic device 900 and the external apparatus.

The memory 909 may be configured to store various data. The memory 909 may include a highspeed random access memory, and may further include a non-volatile memory, etc.

The processor 910 is the control center of the electronic device, connects various portions of the entire electronic device using various interfaces and lines, and performs various functions and processes data of the electronic device by operating or executing software programs and/or modules stored in the memory 909 and by calling data stored in the memory 909, so as to monitor the electronic device as a whole. The processor 910 may include one or more processing units.

In addition, the electronic device 900 includes some functional modules that are not shown, which will not be repeated herein.

In a case where the electronic device includes a power converter 902, the power converter 902 may include a controller (e.g. corresponding to the processor 910) as well as a power conversion circuit. The power conversion circuit is configured to convert input power provided to the power converter by an input power source to output power of a load, the input power source may be an additional power source connected to the power converter, and the load may be an output load connected to the power converter.

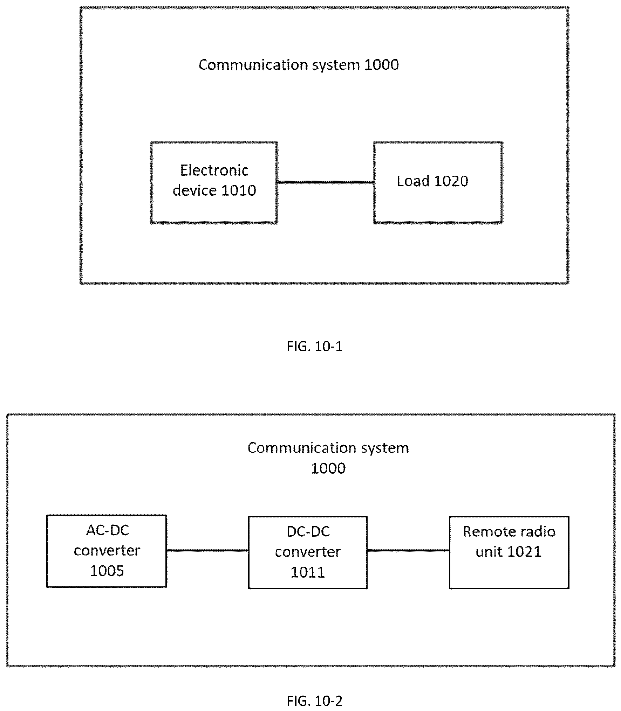

FIG. 10-1 is a schematic diagram of a communication system provided by an embodiment of the present application. As shown in FIG. 10-1, the communication system 1000 provided by the embodiment of the present application may include: an electronic device 1010 and a load 1020. The electronic device is connected to the load. A structure of the electronic device 1010 may refer to FIG. 9. At the same time, the electronic device may include a power converter, and the power converter may be configured to supply power to the load.

In an embodiment, the power converter may be a direct current-direct current converter (DC-DC converter). In this case, as shown in FIG. 10-2, the communication system provided by the embodiment of the present application may further include an alternating current-direct current converter 1005, and the alternating current-direct current converter 1005 is connected to the direct current-direct current converter 1011. Accordingly, the load includes a remote radio unit 1021. The direct current-direct current converter 1011 is connected to the remote radio unit.

As shown in FIG. 10-2, a current output from a power grid may first pass through an alternating current-direct current (AC-DC) converter 1005 to convert the alternating current output from the power grid to a direct current. The current then passes through a direct current-direct current (DC-DC) converter 1011 (corresponding to the power converter 902 in FIG. 9) to distribute power for a power amplifier of the remote radio unit 1021. That is, power distribution may be performed using the DC-DC converter (a power converter) in a communication direct current power supply system.

The communication system provided by the embodiment of the present application may make the communication system operate more smoothly and improve reliability and safety by solving a problem of a high voltage spike caused by a reverse recovery current in the power supply circuit, and by introducing one or more clamping points.

It needs to be noted that in this context, terms "include", "contain", or any other variant thereof, are intended to cover non-exclusive inclusion, so that a process, method, item or apparatus that includes a series of elements includes not only those elements but also other elements that are not explicitly listed or further includes elements that are inherent to such a process, method, item or apparatus. Without more limitations, an element defined by a phrase "including a ..." does not exclude the existence of other identical elements in the process, method, item or apparatus including the element.

Through the description of the above implementation, those of skill in the art can clearly understand that the above embodiment method may be realized by means of software plus a necessary general hardware platform, and of course, it can also be realized by hardware, but in many cases the former is the better implementation.

The embodiments of the present application are described above in conjunction with the accompanying drawings, but the present application is not limited to the above specific implementations, and the above specific implementations are merely schematic and not limiting, and those of ordinary skill in the art, under the inspiration of the present application, can make many forms without departing from the scope of the protection of the purposes and claims of the present application, all of which are under the protection of the present application.

## Claims

1. A power supply circuit, comprising a first power supply end, a second power supply end, a third power supply end, a fourth power supply end, a first inductor, a first switch module, a second switch module, and an auxiliary circuit;
the first power supply end is connected to the second power supply end by means of the first switch module and the first inductor;
the first power supply end is connected to the fourth power supply end by means of the first switch module and the second switch module;
wherein the auxiliary circuit comprises a target module, a third switch module, and a second inductor connected to the first inductor in parallel; and
a first connecting end of the target module is connected to a reference ground, a second connecting end of the target module is connected to a first connecting end of the second inductor, a second connecting end of the second inductor is connected to a first connecting end of the third switch module, and a second connecting end of the third switch module is connected to the reference ground.

2. The power supply circuit according to claim 1, wherein the reference ground is arranged at the first power supply end; the auxiliary circuit further comprises a first diode and a second diode;
the second connecting end of the target module is connected to a first connecting end of the first diode, and a second connecting end of the first diode is connected to a first clamping point, wherein the first clamping point is arranged at the second power supply end or the third power supply end; and
the second connecting end of the second inductor is connected to a first connecting end of the second diode, and a second connecting end of the second diode is connected to a second clamping point, wherein the second clamping point is arranged at the fourth power supply end.

3. The power supply circuit according to claim 2, wherein the power supply circuit comprises an inverting buck boost circuit under a direct current-common architecture; and the first power supply end is a power supply input negative end, the second power supply end is a power supply input positive end, the third power supply end is a power supply output negative end, and the fourth power supply end is a power supply output positive end.

4. The power supply circuit according to claim 1, wherein the reference ground is arranged at the second power supply end; the auxiliary circuit further comprises a first diode and a second diode;
the second connecting end of the target module is connected to a first connecting end of the first diode, and a second connecting end of the first diode is connected to a first clamping point, wherein the first clamping point is arranged at the first power supply end; and
the second connecting end of the second inductor is connected to a first connecting end of the second diode, and a second connecting end of the second diode is connected to the first clamping point.

5. The power supply circuit according to claim 4, wherein the power supply circuit comprises a non-isolated buck circuit under a direct current-common architecture; and the first power supply end is a power supply input positive end, the second power supply end is a power supply output positive end, the third power supply end is a power supply output negative end, and the fourth power supply end is a power supply input negative end.

6. The power supply circuit according to claim 4, wherein the power supply circuit comprises a non-isolated boost circuit under a direct current-common architecture; and the first power supply end is a power supply output positive end, the second power supply end is a power supply input positive end, the third power supply end is a power supply input negative end, and the fourth power supply end is a power supply output negative end.

7. The power supply circuit according to claim 2 or 4, wherein a current passing through the first diode flows from the first connecting end of the first diode to the second connecting end of the first diode; and a current passing through the second diode flows from the first connecting end of the second diode to the second connecting end of the second diode.

8. The power supply circuit according to claim 1, wherein the target module comprises at least one target diode, or, the target module comprises a fourth switch module.

9. The power supply circuit according to claim 1, wherein the power supply circuit further comprises a controller, the first switch module is a first field-effect transistor, the second switch module is a second field-effect transistor, the third switch module is a third field-effect transistor, and switching on or off of the first field-effect transistor, the second field-effect transistor, or the third field-effect transistor is controlled by the controller.

10. An electronic device, comprising the power supply circuit according to any one of claims 1-9.

11. A communication system, comprising a load and the electronic device according to claim 10, wherein the electronic device comprises a power converter connected to the load, and the power converter is configured to supply power to the load.

12. The communication system according to claim 11, wherein the communication system further comprises an alternating current-direct current converter, the alternating current-direct current converter is connected to the power converter, and the load comprises a remote radio unit.
